# EUROPÄISCHE PATENTANMELDUNG

(11) **EP 1 786 253 A2**
(43) Veröffentlichungstag der Anmeldung: **16.05.2007**
(21) Anmeldenummer: 06121215.5
(22) Anmeldetag: 25.09.2006
(51) Int. Cl.: H05K 13/04

(54) **Fertigungssystem und Fertigungsverfahren zum bestücken von Substraten mit elektrischen Bauteilen**

(30) Priorität: 14.11.2005 DE 102005054199
(71) Anmelder: SIEMENS AKTIENGESELLSCHAFT, 80333 München (DE)
(72) Erfinder: Hantke, Klaus, 91325 Adelsdorf (DE)

(57) **Zusammenfassung**

Ein Fertigungssystem (1) umfasst mindestens ein Bestücksystem (2), welches einen Bestückautomaten (6) mit einer daran gekoppelten Zuführeinrichtung (7) für elektrische Bauteile (18) aufweist, eine Zentralsteuerung (15), welche derart ausgebildet ist, dass sie basierend auf einer Information, dass eine aktuelle Anzahl an Bauteilen (18), die von der Zuführeinrichtung (7) vorrätig gehalten werden, mindestens so groß ist wie eine Anzahl an Bauteilen (18), welche bis zur Fertigstellung eines aktuellen Bestückauftrags, bei dem zumindest ein Substrat (4) mittels des Bestückautomats bestückt wird, von der Zuführeinrichtung (7) zuzuführen ist, bestimmt, dass die Zuführeinrichtung (7) vor Beendigung des aktuellen Bestückauftrags mit Bauteilen (18) für einen auf den aktuellen Bestückauftrag folgenden Bestückauftrag rüstbar ist.

## Beschreibung

Die Erfindung betrifft ein Fertigungssystem und ein zugehöriges Fertigungsverfahren zum Bestücken von Substraten mit elektrischen Bauteilen.

In Fertigungssystemen zum Bestücken von Substraten mit elektrischen Bauteilen werden die Bauteile meist von so genannten Zuführeinrichtungen bereitgestellt. Die Bauteile sind in geeigneten Vorratsbehältern, beispielsweise Bauteilgurten, gelagert, mit welchen die Zuführeinrichtungen gerüstet werden. Das Einrüsten kann entweder direkt an der Fertigungslinie oder außerhalb der Fertigungslinie auf so genannten Rüstplätzen erfolgen. Insbesondere bei einem Wechsel zwischen zwei aufeinander folgenden unterschiedlichen Bestückaufträgen müssen die Zuführeinrichtungen mit entsprechend anderen Bauteiltypen gerüstet werden. Erfolgt das Einrüsten direkt an der Fertigungslinie, so wird in der Regel eine so genannte Delta-Rüstung durchgeführt, d. h. es werden nur die zur Durchführung des folgenden Bestückauftrags noch zusätzlich benötigten Bauteile nachgerüstet. Der zeitliche Aufwand für die Delta-Rüstung liegt in der Regel bei mehreren Stunden. Während dieser Zeit steht die betroffene Fertigungslinie still. Ist die Anzahl der zu bestückenden Substrate je Bestückauftrag klein, so folgt daraus, dass die Fertigungslinie häufig still steht. Erfolgt das Einrüsten außerhalb der Fertigungslinie, so wird dort während des Betriebs der Fertigungslinie eine komplette zweite Garnitur von Zuführeinrichtungen aufgerüstet, welche bei dem Wechsel auf dem folgenden Bestückauftrag die Garnitur der Zuführeinrichtung des vorherigen, abgeschlossenen Bestückauftrags ersetzt. Im Idealfall kann die Fertigungslinie nun einen Bestückauftrag abarbeiten, während eine Ersatzgarnitur von Zuführeinrichtungen für den folgenden Bestückauftrag gerüstet wird. Das Stoppen der Fertigungslinie ist nur noch nötig, um die Zuführeinrichtungen auszutauschen. Der Austausch der Zuführeinrichtungen benötigt in der Regel nur wenige Minuten. Es ist jedoch zu bedenken, dass das Aufrüsten der Ersatzgarnitur an Zuführeinrichtungen auch mehrere Stunden benötigt. Damit durch die externe Rüstung einer Ersatzgarnitur an Zuführeinrichtungen außerhalb der Fertigungslinie ein Zeitvorteil entsteht, muss folglich die benötigte Fertigungszeit des aktuell durchgeführten Bestückauftrags mindestens so lang sein, wie die zum Einrüsten des folgenden Bestückauftrags benötigte Zeit. Kurze Bestückaufträge verursachen daher stets hohe Maschinenstillstandzeiten, und hohe Material- und Personalkosten.

Es ist deshalb die Aufgabe der vorliegenden Erfindung ein Fertigungssystem und ein zugehöriges Fertigungsverfahren zu liefern, durch welche der Bestückprozess effektiver gestaltet werden kann.

Die Aufgabe wird durch das Fertigungssystem und das Fertigungsverfahren gemäß den unabhängigen Ansprüchen gelöst. Vorteilhafte Ausgestaltungen sind Gegenstand der Unteransprüche.

Das Fertigungssystem gemäß Anspruch 1 umfasst zumindest ein Bestücksystem, welches einen Bestückautomaten mit einer daran gekoppelten Zuführeinrichtung für elektrische Bauteile aufweist, sowie eine Zentralsteuerung. Die Zentralsteuerung ist derart ausgebildet, dass sie basierend auf einer Information, das eine aktuelle Anzahl an Bauteilen, die von der Zuführeinrichtung vorrätig gehalten wird, mindestens so groß ist wie eine Anzahl an Bauteilen, welche bis zur Fertigstellung eines aktuellen Bestückauftrags, bei dem zumindest ein Substrat mittels des Bestückautomaten bestückt wird, von der Zuführeinrichtung zuzuführen ist, bestimmt, dass die Zuführeinrichtung vor Beendigung des aktuellen Bestückauftrags mit Bauteilen für einen auf den aktuellen Bestückauftrag folgenden Bestückauftrag rüstbar ist. Die genannte Information kann dabei entweder von der Zentralsteuerung selbst generiert werden, oder der Zentralsteuerung durch das Bestücksystem über geeignet Datenverbindungen übermittelt werden. Die aktuelle Anzahl an Bauteilen, welche von der Zuführeinrichtung vorrätig gehalten werden, kann beispielsweise von einer Steuereinrichtung der Zuführeinrichtung bestimmt und von der Zentralsteuerung ausgelesen werden. Die Anzahl an Bauteilen, welche bis zur Fertigstellung des aktuellen Bestückauftrages von der Zuführeinrichtung zuzuführen ist, kann von der Zentralsteuerung beispielsweise basierend auf abgespeicherten fertigungsrelevanten Daten bezüglich des aktuellen Bestückauftrags ermittelt werden. Dadurch, dass bereits vor Beendigung des aktuellen Bestückauftrages bekannt ist, ob die Zuführeinrichtung mit Bauteilen für den darauf folgenden Bestückauftrag rüstbar ist, ergibt sich ein erheblicher Zeitverlust beim Rüsten für den folgenden Bestückauftrag. Stillstandzeiten zwischen zwei aufeinander folgenden Bestückaufträgen können dadurch deutlich verkürzt oder bestenfalls ganz vermieden werden. Somit wird die Effizienz des gesamten Bestückprozesses wesentlich erhöht.

In einer Ausgestaltung nach Anspruch 2 umfasst das Fertigungssystem mehrere Zuführeinrichtungen, wobei die Zentralsteuerung derart ausgebildet ist, dass sie basierend auf vorgegebenen fertigungsrelevanten Daten bezüglich der von dem Fertigungssystem durchzuführenden Bestückaufträgen bestimmt, welche zusätzlichen Arten von Bauteilen zur Durchführung des folgenden Bestückauftrages im Vergleich zum aktuellen Bestückauftrag notwendig sind. Die Zentralsteuerung weist diese zusätzlichen Arten von Bauteilen den Zuführeinrichtungen zu, welche vor Beendigung des aktuellen Bestückauftrags mit Bauteilen für den folgenden Bestückauftrag rüstbar sind. Zu den fertigungsrelevanten Daten zählen beispielsweise die Anzahl der zu bestückenden Substrate pro Bestückauftrag sowie die Anzahl und der Typ der zu verbauenden Bauteile pro Substrat und Bestückauftrag. Derartige Daten können in einer geeigneten Speichereinrichtung, welche der Zentralsteuerung zugeordnet ist, abgelegt sein. Der Bestückprozess wird dadurch verbessert, dass schon während des Ablaufs des aktuellen Bestückauftrags die Zentralsteuerung ermittelt, ob für den folgenden Bestückauftrag zusätzliche Bauteile des gleichen oder eines anderen Typs an den Zuführeinrichtungen gerüstet werden müssen. Da der Zentralsteuerung bekannt ist, welche Zuführeinrichtungen schon während des aktuellen Bestückauftrags für den nachfolgenden Bestückauftrag rüstbar sind, kann sie eine optimale Zuordnung der für den nachfolgenden Bestückauftrag benötigten Bauteile zu den einzelnen Zuführeinrichtungen frühzeitig durchführen.

Gemäß Anspruch 3 ist die Zentralsteuerung derart ausgebildet, dass sie die Zuweisung der zusätzlichen Arten von Bauteilen zu den jeweiligen Zuführeinrichtungen mittels einer Anzeigeeinrichtung anzeigt. Dadurch wird beispielsweise der Maschinenbediener, welcher die Rüstung der entsprechenden Zuführeinrichtungen in der Fertigungslinie vornimmt, zentral und schnell über den folgenden Bestückauftrag informiert werden. Dadurch werden die Fehlerquote und die zur Informationsweitergabe benötigte Zeit erheblich reduziert.

In der Ausgestaltung des Fertigungssystems nach Anspruch 4 umfasst jede Zuführeinrichtungen des Fertigungssystems eine Fördereinrichtung, mittels der die in einem Vorratsbehälter gelagerten Bauteile in einer Förderrichtung zu einer Abholposition transportierbar sind, von welcher die Bauteile von einer Handhabungseinrichtung eines der Zuführeinrichtung zugeordneten Bestückautomaten entnehmbar sind. Die Zuführeinrichtung weisen ferner jeweils eine Steuereinrichtung auf, welche derart ausgebildet ist, dass sie eine aktuelle Anzahl an im Vorratsbehälter gelagerten Bauteilen mit einer Anzahl an Bauteilen, welche bis zur Fertigstellung eines aktuellen Bestückauftrages, bei welchen zumindest ein Substrat mittels des Bestückautomaten bestückt wird, von der Zuführeinrichtung zuzuführen ist, vergleicht und das Ergebnis dieses Vergleichs über eine Datenschnittstelle an die daran gekoppelte Zentralsteuerung übermittelt. Auf Basis dieses Vergleichs kann die Steuereinrichtung beispielsweise ermitteln, ob die aktuelle Anzahl der im Vorratsbehälter gelagerten Bauteile größer, kleiner oder gleich der Anzahl an Bauteilen ist, welche bis zur Fertigungsstellung des aktuellen Bestückauftrages von der Zuführeinrichtung zuzuführen sind. Durch geeignete Ausbildung der Steuereinrichtung kann diese Information durch entsprechende Mittel nach außen angezeigt oder von einer übergeordneten Steuereinrichtung, beispielsweise der Zentralsteuerung des Fertigungssystems, abgerufen werden. Basierend auf dieser Information kann ferner bestimmt werden, ob die Zuführeinrichtung noch vor Abschluss des aktuellen Bestückauftrages durch geeignete Maßnahmen mit Bauteilen für einen auf den aktuellen Bestückauftrag folgenden Bestückauftrag gerüstet werden kann. Dadurch ergibt sich ein Zeitvorteil beim Umrüsten der Zuführeinrichtung auf den folgenden Bestückauftrag, was den gesamten Bestückprozess effektiver macht.

In einer Ausgestaltung des Fertigungssystems nach Anspruch 5 sind die Bauteile in der Förderrichtung in einem einheitlichen Abstand in dem Vorratsbehälter angeordnet. Die Fördereinrichtung ist derart ausgebildet, dass die Bauteile in definierten, einheitlichen Transportschritten, bei welchen die Bauteile jeweils um eine einheitliche Vorschubstrecke in Förderrichtung bewegt werden, zu der Abholposition transportierbar sind. Die Steuereinrichtung ist mit der Fördereinrichtung verbunden und derart ausgebildet, dass sie die Anzahl der im Vorratsbehälter gelagerten Bauteile basierend auf einer vorgegebenen Gesamtzahl an Bauteilen des vollen bzw. neuen Vorratsbehälters, dem Abstand der Bauteile in dem Vorratsbehälter und der Anzahl der durchgeführten Transportschritte ermittelt. Die Gesamtzahl an Bauteilen des vollen Vorratsbehälters kann beispielsweise in einem Speicherelement der Steuereinrichtung abgespeichert sein oder diesem über eine Datenleitung von außen zugeführt werden. Dadurch, dass die Bauteile in Förderrichtung in einem definierten, einheitlichen Abstand in dem Vorratsbehälter angeordnet sind und die Fördereinrichtung die Bauteile in definierten, einheitlichen Transportschritten transportiert, besteht ein fester Zusammenhang zwischen der Anzahl der von der Fördereinrichtung durchgeführten Transportschritte und der Anzahl der Bauteile, welche die Abholposition erreichen und dort, beispielsweise von einem Bestückkopf, dem Vorratsbehälter entnommen werden. Die Steuereinrichtung kann so basierend auf der Anzahl der durchgeführten Transportschritte und der Gesamtzahl der Bauteile des neuen bzw. vollen Vorratsbehälters auf die aktuelle Anzahl der dem Vorratsbehälter entnommenen Bauteile schließen. Dies kann durch Subtraktion der ermittelten Anzahl der entnommenen Bauteile von der vorgegebenen Gesamtzahl an Bauteilen des vollen Vorratsbehälters geschehen. Die Zuführeinrichtung ermöglicht dadurch eine kostengünstige und einfache Ermittlung der aktuellen Anzahl an Bauteilen im Vorratsbehälter.

Das Fertigungssystem kann gemäß Anspruch 6 derart ausgestaltet werden, dass jede Steuereinrichtung derart ausgebildet ist, dass, falls die aktuelle Anzahl der in dem Vorratsbehälter gelagerten Bauteile zumindest so groß ist wie die Anzahl der bis zur Fertigstellung des Bestückauftrags von der Zuführeinrichtung zuzuführenden Bauteile, die Steuereinrichtung diese Information über die Datenschnittstelle an die Zentralsteuerung übermittelt. Dadurch ist die Information, ob die Zuführeinrichtung noch während der Durchführung des aktuellen Bestückauftrags mit Bauteilen für den folgenden Bestückauftrag rüstbar ist, der Zentralsteuerung bekannt und kann basierend darauf entsprechend der Aktionen, wie beispielsweise die Anweisung eines Maschinenbedieners, einleiten. Diese Ausführungsform ist insbesondere dann vorteilhaft, wenn mehrere Zuführeinrichtungen an den Bestückautomaten gekoppelt sind, so dass alle Informationen gesammelt der Zentralsteuerung zugeführt werden, wodurch die Koordinierung zentral ausgeführt wird.

Bei einer Ausgestaltung des Fertigungssystems nach Anspruch 7 handelt es sich bei dem Vorratsbehälter um einen ersten oder zweiten Bauteilgurt, in dem die Bauteile in Förderrichtung in einem einheitlichen Abstand gelagert sind. Jede Zuführeinrichtung des Fertigungssystems weist einen Hauptfördermechanismus auf, mittels welchem die Bauteile des ersten oder des zweiten Bauteilgurts in einer Förderrichtung zu der Abholposition transportierbar sind. Ferner ist eine Erfassungseinrichtung in Förderrichtung vor der Abholposition vorgesehen, um das Ende des jeweiligen durch den Hauptfördermechanismus transportierten ersten oder zweiten Bauteilgurtes zu erfassen. Die Zuführeinrichtung umfasst ferner einen ersten Hilfsfördermechanismus, um den ersten Bauteilgurt im Anschluss an das Ende des zweiten Bauteilgurts dem Hauptfördermechanismus zuzuführen, falls die Erfassungseinrichtung das Ende des zweiten Bauteilgurts erfasst. Zusätzlich ist ein zweiter Hilfsfördermechanismus vorgesehen, um den zweiten Bauteilgurt im Anschluss an das Ende des ersten Bauteilgurtes dem Hauptfördermechanismus zuzuführen, falls die Erfassungseinrichtung das Ende des ersten Bauteilgurts erfasst. Derartige Zuführeinrichtungen sind gleichzeitig mit zwei Bauteilgurten rüstbar. Sobald das Ende eines aktuell geförderten bzw. transportierten Bauteilgurtes durch die Erfassungseinrichtung erkannt wird, wird der zweite Bauteilgurt automatisch nachgeführt, so dass ein händisches Nachführen des Bauteilgurtes oder ein Verbinden der Bauteilgurte nicht mehr notwendig ist. Dadurch wird das Zeitfenster zum Nachlegen eines Bauteilgurtes bei Auslaufen eines aktuell geförderten Bauteilgurtes erheblich vergrößert, so dass der Maschinenbediener über ausreichend Zeit zum Nachlegen eines neuen Bauteilgurts verfügt. Dadurch wird auch die Prozesssicherheit des ganzen Bestückvorganges deutlich gesteigert.

Die Zuführeinrichtungen des Fertigungssystems gemäß Anspruch 10 sind jeweils mit einer Schneideeinrichtung zum Durchtrennen des ersten und zweiten Bauteilgurtes ausgestattet sein, welche in Förderrichtung in einer vorgegebenen Distanz zur Abholposition angeordnet und mit der Steuereinrichtung verbunden ist. Die Steuereinrichtung ist dabei derart ausgebildet, dass sie denjenigen des ersten oder zweiten Bauteilgurtes, welcher von dem Hauptfördermechanismus gefördert wird, mittels der Schneideeinrichtung durchtrennt, wenn die Anzahl der zur Fertigstellung des aktuellen Bestückauftrages von der Zuführeinrichtung zuzuführenden Bauteile gleich oder kleiner der Anzahl der sich zwischen der Schneideeinrichtung und der Abholposition befindlichen Bauteile ist. Der einheitliche Abstand der Bauteile am Bauteilgurt und die Distanz zwischen der Schneideeinrichtung und der Abholposition sind der Steuereinrichtung bekannt. Dadurch kann die Steuereinrichtung basierend auf diesen Daten auf die Anzahl der zwischen der Schneideeinrichtung und der Abholposition befindlichen Bauteile schließen. Gleichzeitig ist der Steuereinrichtung die Anzahl der zur Fertigstellung des aktuellen Bestückauftrages von der Zuführeinrichtung zuzuführenden Bauteile bekannt. Sobald die Steuereinrichtung feststellt, dass die Anzahl der Bauteile, welche sich zwischen der Schneideeinrichtung und der Abholposition befinden, zur Fertigstellung des aktuellen Bestückauftrages ausreichen, steuert diese die Schneideeinrichtung derart an, dass der Bauteilgurt durchgeschnitten wird. Wie bezüglich des Anspruchs 7 ausgeführt wurde, wird der jeweils andere Bauteilgurt nachgeführt, nachdem die Erfassungseinrichtung das Ende des aktuell transportierten Bauteilgurtes erfasst hat. Somit wird ein reibungsloser, automatisierter Übergang bei einem Wechsel der Bestückaufträge sichergestellt.

Bei dem Fertigungssystem gemäß Anspruch 9 sind die Steuereinrichtungen der Zuführeinrichtungen derart ausgebildet, dass sie nach Fertigstellung des aktuellen Bestückauftrages den Bauteilgurt, welcher im Anschluss an das Ende des durchtrennten Bauteilgurtes zugeführt wird, mittels des Hauptfördermechanismus so lange fördert, bis sich das in Förderrichtung erste Bauteil dieses Bauteilgurtes an der Abholposition befindet. Dadurch kann der neue Bestückauftrag in sehr kurzer Zeit und ohne händisches Eingreifen durch den Maschinenbediener nach Beendigung des alten Bestückauftrages gestartet werden.

Ein Fertigungsverfahren für ein Fertigungssystem nach Anspruch 1 ist Gegenstand der Ansprüche 10 und 11. Die detaillierten Ausführungen bezüglich der Ansprüche 1 und 2 sind analog auf das Fertigungsverfahren gemäß den Ansprüchen 10, 11 übertragbar und auch die genannten Vorteile gelten analog.

Im Folgenden wird die vorliegende Erfindung anhand von Ausführungsbeispielen unter Bezug auf die beigefügten Figuren näher erläutert. In den Figuren sind:
Figur 1 eine schematische Ansicht eines erfindungsgemäßen Fertigungssystems,
Figur 2 eine schematische Ansicht eines ersten Ausführungsbeispiels einer Zuführeinrichtung des Fertigungssystems,
Figur 3 eine schematische Ansicht eines zweiten Ausführungsbeispiels der Zuführeinrichtung.

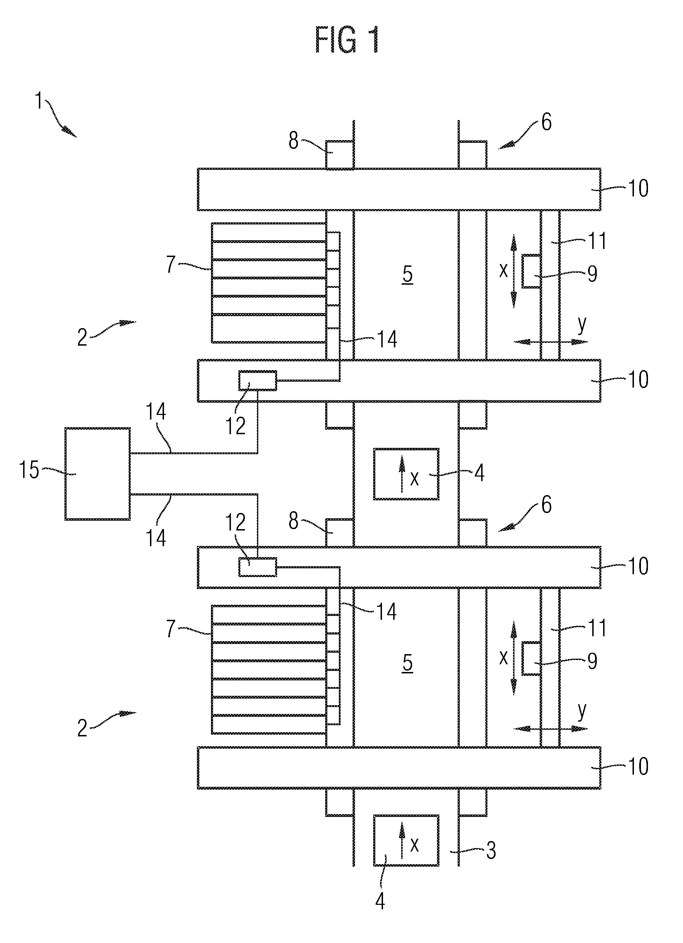

Ein Ausführungsbeispiel des erfindungsgemäßen Fertigungssystems 1 ist in Figur 1 schematisch dargestellt. Das Fertigungssystem 1 umfasst zwei Bestücksysteme 2, welche über eine Transportstrecke 3 für zu bestückende Substrate 4 miteinander verbunden sind. Im Ausführungsbeispiel sind die beiden Bestücksysteme 2 gleichartig ausgebildet, sodass die Beschreibung für beide Bestücksysteme 2 zutrifft. Die zu bestückenden Substrate 4 werden über die Transportstrecke 3 in einer Transportrichtung (Pfeil X) zu Bestückplätzen 5 der Bestücksysteme 2 transportiert, dort bestückt und weiter transportiert. Jedes Bestücksystem 2 weist einen Bestückautomaten 6 und mehrere seitlich der Transportstrecke 3 an die Bestückautomaten 6 gekoppelte Zuführeinrichtungen 7 für elektrische Bauteile. Die Transportstrecke 3 ist dabei über ein Chassis 8 des Bestückautomaten 6 geführt. Jeder Bestückautomat 6 umfasst ferner ein Positioniersystem für einen Bestückkopf 9, welches jeweils aus zwei Trägerbalken 10 besteht, welche die Transportstrecke 3 quer zur Transportrichtung brückenartig überspannen. Das Positioniersystem umfasst ferner einen Trägerarm 11, welcher an beiden Enden quer zur Förderrichtung verschiebbar an den Trägerbalken 10 angebracht ist. An dem Trägerarm 11 selbst ist der Bestückkopf 9 angeordnet, welcher in der Transportrichtung verschiebbar ist. Zum Bestücken der Substrate 4 mit elektrischen Bauteilen wird der Bestückkopf 9 mittels des Positioniersystems zunächst in einen Abholbereich des Bestückautomaten 6, in dem die Zuführeinrichtungen 7 angeordnet sind, verfahren, um dort Bauteile aufzunehmen. Anschließend wird der Bestückkopf 9 zu dem Bestückplatz 5 bewegt, wo das zu bestückende Substrat 4 bereit steht. Das Substrat 4 wird dann durch den Bestückkopf 9 mit elektrischen Bauteilen bestückt.

Der Bestückautomat 6 umfasst ferner eine Hauptsteuerung 12, welche die Vorgänge am Bestückautomat 6 steuert und koordiniert, wie beispielsweise die Bewegungen des Positioniersystems. Jede der Zuführeinrichtungen 7 ist mit einer Steuereinrichtung 13 ausgerüstet, welche die Abläufe in der jeweiligen Zuführeinrichtung 7 koordiniert und steuert. Die Steuereinrichtungen 13 sind jeweils über Datenverbindungen 14 mit der Hauptsteuerung 12 des Bestückautomaten 6 verbunden.

Die Hauptsteuerungen 12 der Bestückautomaten 6, sowie die einzelnen Steuereinrichtungen 13 der Zuführeinrichtungen 7 sind über Datenverbindungen 14 mit einer Zentralsteuerung 15 des Fertigungssystems 1 verbunden, welche die Abläufe an den einzelnen Bestücksystemen 2 koordiniert. Die Zentralsteuerung 15 weist eine Speichereinrichtung (nicht dargestellt) auf, in welcher fertigungsrelevante Daten bezüglich der von dem Fertigungssystem 1 durchzuführenden Bestückaufträge abgespeichert sind. Zu den fertigungsrelevanten Daten zählen beispielsweise die Anzahl und Art der zu bestückenden Substrate 4 je Bestückauftrag, sowie die Anzahl und Art der auf den einzelnen Substraten 4 zu platzierenden Bauteile.

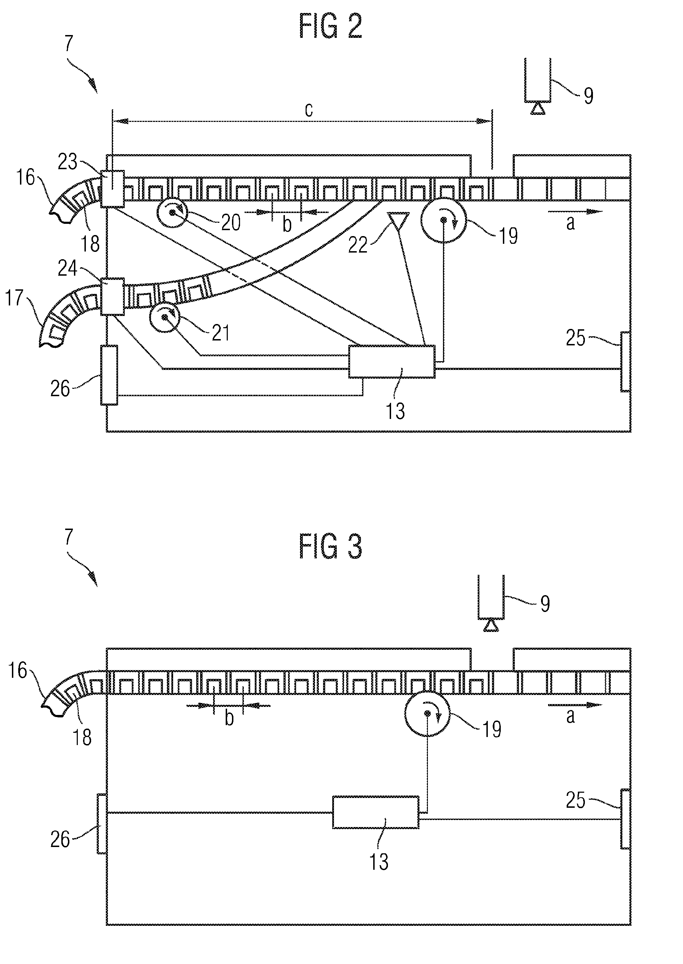

In Figur 2 ist schematisch ein erstes Ausführungsbeispiel einer Zuführeinrichtung 7 des Fertigungssystems 1 dargestellt. Diese Zuführeinrichtung 7 ist derart ausgebildet, dass sie in einem Bauteilgurt 16, 17 gelagerte Bauteile 18 in einer Förderrichtung (Pfeil a) zu einer Abholposition mittels einer Fördereinrichtung 19 transportiert. Die dabei verwendeten Bauteilgurte 16, 17 weisen taschenartige Vertiefungen auf, in denen die Bauteile 18 in einem definierten und einheitlichen Abstand (b) in Förderrichtung hintereinander angeordnet sind. An der Abholposition werden die Bauteile 18 durch eine Handhabungseinrichtung 9, wie beispielsweise dem Bestückkopf 9 des Bestückautomaten 6, aus den taschenartigen Vertiefungen entnommen.

Im Falle des ersten Ausführungsbeispiels umfasst die Fördereinrichtung 19 einen Hauptfördermechanismus 19, welcher die Bauteilgurte 16, 17 zu der Abholposition befördert. Der Hauptfördermechanismus 19 kann beispielsweise durch ein Transportrad mit radial abstehenden Stiften realisiert werden, die in entsprechenden Perforationen am Bauteilgurt 16, 17 eingreifen. Der Hauptfördermechanismus 19 transportiert die in dem Bauteilgurt 16, 17 befindlichen Bauteile 18 in definierten einheitlichen Transportschritten zu der Abholposition. Aufgrund der einheitlichen und definierten Vorschubstrecke pro Transportschritt und dem einheitlichen und definierten Abstand (b) der Bauteile 18 am Bauteilgurt 16, 17 besteht ein eindeutiger Zusammenhang zwischen der Anzahl der Transportschritte und der Anzahl der zur Abholposition geförderten Bauteile 18 bzw. der Anzahl der dort durch den Bestückkopf 9 entnommenen Bauteile 18. Die Bedeutung dieses eindeutigen Zusammenhangs wird im Verlauf der weiteren Beschreibung deutlich werden.

Die Zuführeinrichtung 7 umfasst des Weiteren einen ersten Hilfsfördermechanismus 20 und einen zweiten Hilfsfördermechanismus 21, welche beide einen ähnlichen Aufbau wie der Hauptfördermechanismus 19 aufweisen. Der erste und der zweite Hilfsfördermechanismus 20, 21 sind so ausgestaltet, dass sie einen ersten Bauteilgurt 16 bzw. einen zweiten Bauteilgurt 17 hintereinander dem Hauptfördermechanismus 19 zuführen.

In Förderrichtung vor der Abholposition ist eine Erfassungseinrichtung 22 so angeordnet, dass sie das Ende des vom dem Hauptfördermechanismus 19 gerade transportierten ersten oder zweiten Bauteilgurts 16, 17 erfasst. In dem in Figur 2 dargestellten Ausführungsbeispiel befindet sich die Erfassungseinrichtung 22 in der Förderrichtung vor dem Hauptfördermechanismus 19. Die Erfassungseinrichtung 22 kann beispielsweise als optischer Sensor, welcher eine Markierung am Ende des Bauteilgurtes 16, 17 erkennt, oder als Durchgangslichtschranke ausgebildet sein.

Die Zuführeinrichtung 7 ist ferner mit einer ersten Schneideeinrichtung 23 und einer zweiten Schneideeinrichtung 24 zum Durchtrennen des ersten bzw. des zweiten Bauteilgurtes 17 ausgestattet. Die erste Schneideeinrichtung 23 und die zweite Schneideeinrichtung 24 sind in Förderrichtung jeweils in einer definierten Distanz (c) zur Abholposition angeordnet.

Wie bezüglich der Figur 1 schon erwähnt wurde, weist die Zuführeinrichtung 7 eine Steuereinrichtung 13 auf, welche die Abläufe innerhalb der Zuführeinrichtung 7 koordiniert und steuert. Dazu ist die Steuereinrichtung 13 mit dem Hauptfördermechanismus 19, dem ersten und zweiten Hilfsfördermechanismus 20, 21, sowie mit der ersten und zweiten Schneideeinrichtung 23, 24 verbunden. In einem Zustand, in dem die Zuführeinrichtung 7 an dem Bestückautoamten 6 gekoppelt ist, ist die Steuereinrichtung 13 über eine entsprechende Datenschnittstelle 22 mit der Hauptsteuerung 12 des Bestückautomaten 6 und der Zentralsteuerung 15 des Fertigungssystems 1 verbunden. Zur Anzeige von Informationen ist an der Zuführeinrichtung 7 zusätzlich eine Anzeigeeinrichtung 26 vorgesehen. Diese ist mit der Steuereinrichtung 13 verbunden, so dass Informationen, beispielsweise für einen Maschinenbediener, von der Steuereinrichtung 13 über diese Anzeigeeinrichtung 26 nach außen ausgegeben werden können.

Im Folgenden wird die Funktionsweise der in Figur 2 dargestellten Zuführeinrichtung 7 näher beschrieben. Zunächst wird die Zuführeinrichtung 7 mit dem ersten und zweiten Bauteilgurt 16, 17 gerüstet. Dazu wird dem ersten Hilfsfördermechanismus 20 der erste Bauteilgurt 16 und dem zweiten Hilfsfördermechanismus 21 der zweite Bauteilgurt 17 zugeführt. Der erste Hilfsfördermechanismus 20 führt dem Hauptfördermechanismus 19 den ersten Bauteilgurt 16 zu. Sobald der erste Bauteilgurt 16 mit dem Hauptfördermechanismus 19 in Eingriff steht, übernimmt der Hauptfördermechanismus 19 den Weitertransport des ersten Bauteilgurtes 16 und der erste Hilfsfördermechanismus 20 wird von der Steuereinrichtung 13 passiv geschaltet. Der Hauptfördermechanismus 19 fördert den ersten Bauteilgurt 16 solange in der Förderrichtung, bis das erste Bauteil 18 an der Abholposition positioniert ist. Bei Aufnahme des Bestückvorganges holt der Bestückkopf 9 die Bauteile 18 aus dem ersten Bauteilgurt 16 ab. Sobald ein Bauteil 18 abgeholt wurde, wird der Hauptfördermechanismus 19 von der Steuereinrichtung 13 derart angesteuert, dass er den ersten Bauteilgurt 16 in Förderrichtung so weiter transportiert, dass das nächste Bauteil 18 zur Abholposition gelangt. Wird das Ende des ersten Bauteilgurtes 16 durch die Erfassungseinrichtung 22 erfasst, steuert die Steuereinrichtung 13 den in Warteposition gehaltenen zweiten Hilfsfördermechanismus 21 derart an, dass dieser den zweiten Bauteilgurt 17 unmittelbar im Anschluss an das Ende des ersten Bauteilgurtes 16 dem Hauptfördermechanismus 19 zuführt. Die Annäherung des zweiten Bauteilgurtes 17 an das Ende des ersten Bauteilgurtes 16 wird von der Erfassungseinrichtung 22 erkannt. Daraufhin synchronisiert die Steuereinrichtung 13 den zweiten Hilfsfördermechanismus 21 mit dem Hauptfördermechanismus 19. Der zweite Bauteilgurt 17 wird dem Hauptfördermechanismus 19 im selben Fördertakt und mit denselben Transportschritten derart zugeführt, dass der Abstand zwischen dem letzten sich auf dem ersten Bauteilgurt 16 befindlichen Bauteil 18 zu dem ersten sich auf dem zweiten Bauteilgurt 17 befindlichen Bauteil 18 gleich dem Abstand der auf dem ersten Bauteilgurt 16 befindlichen Bauteile 18 ist. Dadurch wird gewährleistet, dass selbst an der Übergangsstelle zwischen dem ersten und dem zweiten Bauteilgurt 16, 17 der Abstand zwischen den Bauteilen 18 derselbe ist, wie er bereits auf dem ersten Bauteilgurt 16 vorherrscht. Sobald der erste Bauteilgurt 16 aus dem Hauptfördermechanismus 19 ausläuft, übernimmt der Hauptfördermechanismus 19 den Transport des zweiten Bauteilgurtes 17. Währenddessen kann von einem Maschinenbediener bereits ein neuer Bauteilgurt dem ersten Hilfsfördermechanismus 20 zugeführt werden. Erfasst die Erfassungseinrichtung 22 das Ende des zweiten Bauteilgurtes 17, so wird auch der neue Bauteilgurt analog dem oben beschriebenen Vorgang dem Hauptfördermechanismus 19 zugeführt, so dass der Fördervorgang ohne Unterbrechung weitergeführt werden kann.

Wie oben schon erwähnt wurde, sind in der Zentralsteuerung 15 sämtliche fertigungsrelevanten Daten für die von den Bestücksystemen 2 durchzuführenden Bestückaufträge abgespeichert. Unter diesen fertigungsrelevanten Daten befinden sich auch Informationen über die Art und die Anzahl der von den Zuführeinrichtungen 7 pro Bestückauftrag und pro Substrat 4 zu fördernden Bauteile 18. Diese Informationen können von der Zentralsteuerung 15 an die Steuereinrichtungen 13 der jeweiligen Zuführeinrichtungen 7 übermittelt werden. Dadurch ist jeder Steuereinrichtung 13 die Anzahl an Bauteilen 18 bekannt, welche bis zur Fertigstellung eines aktuellen Bestückauftrages von der Zuführeinrichtung 7 zuzuführen ist. Standardmäßig ist in jedem vollen Bauteilgurt 16, 17 eine bestimmte Gesamtzahl an Bauteilen 18 in einem einheitlichen, definierten Abstand (b) zueinander gelagert. Auch diese Information ist als fertigungsrelevantes Datum in der Zentralsteuerung 15 gespeichert und kann den Steuereinrichtungen 13 der Zuführeinrichtungen 7 übermittelt werden. Dadurch kann die Steuereinrichtung 13 anhand der Anzahl der durch den Hauptfördermechanismus 19 durchgeführten definierten Förderschritte ermitteln, wie viele Bauteile 18 von dem Hauptfördermechanismus 19 zur Abholposition befördert und von dort durch den Bestückkopf 9 abgeholt wurden. Die Steuereinrichtung 13 ist derart ausgebildet, dass sie aus der Differenz aus der vorgegebenen Gesamtzahl an Bauteilen 18 des vollen Bauteilgurtes 16, 17 und der Anzahl der zur Abholposition geförderten und dort abgeholten Bauteile 18 eine aktuelle Anzahl an im Bauteilgurt 16, 17 gelagerten Bauteilen 18 berechnet. Die Steuereinrichtung 13 vergleicht die aktuelle Anzahl der im Bauteilgurt 16, 17 gelagerten Bauteile 18 mit der von der Zentralsteuerung 15 gelieferten Anzahl an Bauteilen 18, welche bis zur Fertigstellung des aktuellen Bestückauftrages von der Zuführeinrichtung 7 zuzuführen sind. Das Ergebnis dieses Vergleichs kann beispielsweise der Zentralsteuerung 15 übermittelt werden. Es ist jedoch auch möglich, dass die Steuereinrichtung 13 das Ergebnis des Vergleichs über die Anzeigeeinrichtung 26 einem Maschinenbediener anzeigt.

Erkennt die Steuereinrichtung 13 aufgrund des Vergleichs, dass die aktuelle Anzahl der im Bauteilgurt 16, 17 gelagerten Bauteile 18 zumindest so groß ist wie die Anzahl der bis zur Fertigstellung des aktuellen Bestückauftrages von der Zuführeinrichtung 7 zuzuführenden Bauteile 18, so übermittelt die Steuereinrichtung 13 diese Information an die Hauptsteuerung 12 des Bestückautomaten 6 oder die Zentralsteuerung 15, oder zeigt dies direkt mittels der Anzeigeeinrichtung 26 an. Basierend auf dieser Information erkennt die Zentralsteuerung 15, dass die Zuführeinrichtung 7, welche die Information übermittelt hat, vor Beendigung des aktuellen Bestückauftrages mit Bauteilen 18 für einen auf den aktuellen Bestückauftrag folgenden Bestückauftrag rüstbar ist. Im Ausführungsbeispiel gemäß Figur 2 wäre dies dadurch möglich, dass während der erste Bauteilgurt 16 zur Durchführung des ersten Bestückauftrages verwendet wird, schon der zweite Bauteilgurt 17, welcher Bauteile 18 für die Durchführung des folgenden Bestückauftrages enthält, dem zweiten Hilfsfördermechanismus 21 zugeführt wird. Ist der aktuelle Bestückauftrag beendet, so steuert die Steuereinrichtung 13 der jeweiligen Zuführeinrichtung 7 den Hauptfördermechanismus 19 derart an, dass dieser die restlichen Bauteile 18 des ersten Bauteilgurtes 16 aus der Zuführeinrichtung 7 ausschleust. Nach Erkennen des Endes des ersten Bauteilgurtes 16 durch die Erfassungseinrichtung 22 steuert die Steuereinrichtung 13 den zweiten Hilfsfördermechanismus 21 derart an, dass der zweite Bauteilgurt 17 für den folgenden Bestückauftrag automatisch dem Hauptfördermechanismus 19 zugeführt wird.

Die Zentralsteuerung 15 bestimmt ferner basierend auf den abgespeicherten fertigungsrelevanten Daten, welche zusätzliche Arten von Bauteilen 18 zur Durchführung des folgenden Bestückauftrages im Vergleich zum aktuellen Bestückauftrag notwendig sind und weist diese zusätzlichen Arten von Bauteilen 18 denjenigen Zuführeinrichtungen 7 zu, welche vor Beendigung des aktuellen Bestückauftrages mit Bauteilen 18 für den folgenden Bestückauftrag gerüstet werden können.

Durch die Erfindung ist es daher möglich, noch während der Durchführung eines aktuellen Bestückauftrages die Zuführeinrichtungen 7 in der Fertigungslinie mit Bauteilen 18 für den folgenden Bestückauftrag zu rüsten. Dadurch werden Zeitverluste, wie sie durch ein Rüsten der Zuführeinrichtungen 7 nach Beendigung eines aktuellen Bestückauftrages auftreten, deutlich verringert werden. Im idealen Fall können während Durchführung des aktuellen Bestückauftrages sämtliche zusätzliche Arten von Bauteilen 18 für den folgenden Bestückauftrag an den Zuführeinrichtungen 7 gerüstet werden. In diesem Fall kann der folgende Bestückauftrag praktisch ohne Unterbrechung nach Fertigstellung des aktuellen Bestückauftrages durchgeführt werden.

Während des Bestückvorganges kann es vorkommen, dass der Bestückkopf 9 das gerade von der Zuführeinrichtung 7 abgeholte Bauteil 18 verliert, oder er dieses in einer derart ungünstigen Lage abholt, dass es nicht verbaut werden kann. Das Bauteil 18 wird dann meist verworfen und der Abholvorgang muss wiederholt werden. Zur Erhöhung der Prozess-Sicherheit berücksichtigt die Steuereinrichtung 13 bei dem von ihr durchgeführten Vergleich eine Sicherheitsanzahl. Falls die Summe der Anzahl der im Bauteilgurt gelagerten Bauteile 18 und dieser Sicherheitsanzahl so groß ist wie die Anzahl der bis zur Fertigstellung des aktuellen Bestückauftrages durch die Zuführeinrichtung 7 zuzuführenden Bauteile 18 ist, so übermittelt die Steuereinrichtung 13 diese Information an die Zentralsteuerung 15 bzw. an die Hauptsteuerung 12. Zur Bestimmung der Abholfehler ermittelt die Steuereinrichtung 13 für jedes Substrat 4 innerhalb des aktuellen Bestückauftrages die Anzahl der tatsächlich benötigten Transportschritte der Fördereinrichtung 19 bzw. die Anzahl der tatsächlich zugeführten Bauteile 18 pro Substrat 4. Davon wird der maximale Wert, d.h. die maximale Anzahl an tatsächlich benötigten Transportschritten bzw. an tatsächlich zugeführten Bauteilen 18 pro Substrat 4, abgespeichert. Gleichzeitig ist der Steuereinrichtung 13 eine theoretische Anzahl an Bauteilen 18, welche von der Zuführeinrichtung 7 pro Substrat 4 innerhalb des aktuellen Bestückauftrages zuzuführen sind, durch die in der Zentralsteuerung 15 abgespeicherten fertigungsrelevanten Daten bekannt. Die Steuereinrichtung 13 ermittelt die Sicherheitsanzahl dadurch, dass sie die theoretische Anzahl an Bauteilen 18, welche von der Zuführeinrichtung 7 pro Substrat 4 zuzuführen sind, von der maximalen Anzahl an tatsächlich zugeführten Bauteilen 18 pro Substrat 4 innerhalb des aktuellen Bestückauftrags abzieht. Dadurch wären die Abholfehler bei der Beurteilung, ob eine Zuführeinrichtung 7 noch während des aktuellen Bestückauftrages mit Bauteilen 18 für den folgenden Bestückauftrag gerüstet werden können, berücksichtigt. Dies erhöht die Prozesssicherheit.

Wie oben schon erwähnt wurde, umfasst die Zuführeinrichtung 7 eine erste Schneideeinrichtung 23 und eine zweite Schneideeinrichtung 24, welche jeweils in einer definierten Distanz
(c) zur Abholposition in Förderrichtung vor der Abholposition angeordnet ist. Dadurch, dass auch die Bauteile 18 in einem festen einheitlichen Abstand (b) am ersten und zweiten Bauteilgurt 16, 17 angeordnet sind, ist auch die Anzahl der sich zwischen der ersten Schneideeinrichtung 23 bzw. der zweiten Schneideeinrichtung 24 und der Abholposition befindlichen Bauteile 18 bekannt. Die Steuereinrichtung 13 steuert die erste und zweite Schneideeinrichtung 23, 24 jeweils derart an, dass diese den ersten bzw. zweiten Bauteilgurt 16, 17 durchtrennt, wenn die Anzahl der sich zwischen der ersten bzw. zweiten Schneideeinrichtung 23, 24 und der Abholposition befindlichen Bauteile 18 mindestens genauso groß ist, wie die zur Fertigstellung des aktuellen Bestückauftrages von der Zuführeinrichtung 7 zuzuführen Bauteile 18. Auch dabei kann wiederum die Sicherheitsanzahl mit einberechnet werden.

In dem obigen Ausführungsbeispiel der Zuführeinrichtung 7 können aufgrund des ersten und zweiten Hilfsfördermechanismus 20, 21 gleichzeitig zwei Bauteilgurte 16, 17 an der Zuführeinrichtung 7 gerüstet sein. Die Erfindung ist jedoch auch auf eine Zuführeinrichtung 7 übertragbar, deren Fördereinrichtung 19 nur einen Fördermechanismus aufweist, durch welchen nur ein einzelner Bauteilgurt 16 befördert werden kann. Eine derartige Zuführeinrichtung 7 ist in Figur 3 dargestellt. Die darin abgebildete Zuführeinrichtung 7 unterscheidet sich von der Zuführeinrichtung 7 nach Figur 2 dadurch, dass ihr der erste und zweite Hilfsfördermechanismus 20, 21 sowie die Erfassungseinrichtung 22 und die erste und zweite Schneideeinrichtung 23, 24 fehlen. Bis auf diese Unterscheide ist die Beschreibung bezüglich des Ausführungsbeispiels nach Figur 2 analog übertragbar. Auch wenn im Unterschied zu dem Ausführungsbeispiel gemäß Figur 2 hier nur ein einzelner Bauteilgurt 16 befördert werden kann, kann auch diese Zuführeinrichtung 7 schon während des Durchführung eines aktuellen Bestückauftrages mit einem Bauteilgurt für den folgenden Bestückauftrag gerüstet werden, indem dieser Bauteilgurt an das Ende des aktuell geförderten Bauteilgurt durch geeignete Verbindungsmaßnahmen (Splice) verbunden wird. Hat also die Steuereinrichtung 13 bzw. die Zentralsteuerung 15 erkannt, dass diese Zuführeinrichtung 7 noch während der Durchführung des aktuellen Bestückauftrages schon mit Bauteilen 18 für den darauf folgenden Bestückauftrag gerüstet werden kann und hat die Zentralsteuerung 15 dieser Zuführeinrichtung 7 die entsprechenden Bauteile 18 zugewiesen, so kann dies über geeignete Anzeigeeinrichtungen einem Maschinenbediener mitgeteilt werden. Dieser kann dann den Bauteilgurt, in welchem die Bauteile 18 für den folgenden Bestückauftrag gelagert sind, an den aktuell geförderten Bauteilgurt 16 anheften. Ist der aktuelle Bestückauftrag beendet, so steuert die Steuereinrichtung 13 die Fördereinrichtung 19 bzw. das Transportrad derart an, dass sie die restlichen Bauteile 18 des Bauteilgurtes 16 für den aktuell abgeschlossenen Bestückauftrag ausschleust und soweit transportiert, dass das erste Bauteil 18 des Bauteilgurtes für den folgenden Bestückauftrag an der Abholposition bereitsteht. Somit kann der folgende Bestückauftrag mit nur kurzer Unterbrechung gestartet werden.

Durch die Erfindung ist es möglich, den Zeitverlust aufgrund der Rüstzeiten zwischen zwei aufeinander folgenden Bestückaufträgen erheblich zu reduzieren. Eine so genannte Delta-Rüstung ist in der Fertigungslinie ohne Zeitverzögerung möglich, da diese schon während der Durchführung eines aktuellen Bestückauftrages gemacht werden kann. Eine externe Rüstung, welche material-, zeit- und personalaufwendig ist, ist nicht notwendig. Dadurch können Kosten reduziert und die gesamte Effizienz des Bestückprozesses verbessert werden.

Im dargestellten Ausführungsbeispiel wird die Information, dass die aktuelle Anzahl an Bauteilen 18, die von einer der Zuführeinrichtungen 7 vorrätig gehalten werden, mindestens so groß ist wie eine Anzahl an Bauteilen 18, welche bis zur Fertigstellung eines aktuellen Bestückauftrags von der Zuführeinrichtung 7 zuzuführen ist, durch die Steuereinrichtung 13 der jeweiligen Zuführeinrichtung 7 generiert und an die Zentralsteuerung übermittelt wird. Es ist jedoch nicht unbedingt notwendig, dass die genannte Information von den Steuereinrichtungen 13 der einzelnen Zuführeinrichtungen 7 erzeugt wird. Der Erfindungsgedanke umfasst beispielsweise auch die Alternativen, dass die Hauptsteuerung 12 des Bestückautomaten 6, die Zentralsteuerung 15 oder eine andere Recheneinheit des Fertigungssystems diese Information bildet. Zu diesem Zweck kann die Gesamtzahl der in einem vollen Bauteilgurt enthaltenen Bauteile 18 beispielsweise in der Hauptsteuerung 12 oder der Zentralsteuerung 15 abgespeichert sein und die Anzahl der von einem Bauteilgurt entnommenen Bauteile 18 durch die Anzahl der Transportschritte der Fördereinrichtungen der Zuführeinrichtungen 7 oder durch die Anzahl der Entnahmevorgänge des Bestückkopfs 9 ermittelt werden. Die aktuellen Anzahlen an Bauteilen 18, die von den Zuführeinrichtungen 7 vorrätig gehalten werden, werden dann durch einfache Subtraktion von der Hauptsteuerung 12 oder der Zentralsteuerung 15 bestimmt.

Auch wenn es sich im obigen Ausführungsbeispiel um eine Zuführeinrichtung 7 zum Zuführen von in einem Bauteilgurt gelagerten Bauteilen 18 handelt, so ist doch die Erfindung auch auf andere Arten von Zuführeinrichtungen 7 übertragbar. Als Beispiel wäre zu nennen, dass als Vorratsbehälter nicht ein Bauteilgurt dient, sondern ein längliches Magazin, in dem die Bauteile 18 hintereinander gelagert sind und durch einen mechanischen, pneumatisch oder elektrisch betätigten Schieber (entspricht der Fördereinrichtung) zu einer Abholposition transportiert werden. Ferner ist als Vorratsbehälter auch ein so genannter Tray (Tablett), wie er beispielsweise in einem Tray-Feeder zum Einsatz kommt, denkbar.

## Patentansprüche

1. Fertigungssystem (1) mit
- mindestens einem Bestücksystem (2), welches einen Bestückautomaten (6) mit einer daran gekoppelten Zuführeinrichtung (7) für elektrische Bauteile (18) aufweist,
- einer Zentralsteuerung (15), welche derart ausgebildet ist, dass sie basierend auf einer Information, dass eine aktuelle Anzahl an Bauteilen (18), die von der Zuführeinrichtung (7) vorrätig gehalten werden, mindestens so groß ist wie eine Anzahl an Bauteilen (18), welche bis zur Fertigstellung eines aktuellen Bestückauftrags, bei dem zumindest ein Substrat (4) mittels des Bestückautomats bestückt wird, von der Zuführeinrichtung (7) zuzuführen ist, bestimmt, dass die Zuführeinrichtung (7) vor Beendigung des aktuellen Bestückauftrags mit Bauteilen (18) für einen auf den aktuellen Bestückauftrag folgenden Bestückauftrag rüstbar ist.

2. Fertigungssystem (1) nach Anspruch 1, mit mehreren Zuführeinrichtungen (7), wobei die Zentralsteuerung (15) derart ausgebildet ist, dass sie basierend auf vorgegebenen fertigungsrelevanten Daten des aktuellen Bestückauftrags und des folgenden Bestückauftrags bestimmt, welche zusätzlichen Arten von Bauteilen (18) zur Durchführung des folgenden Bestückauftrags im Vergleich zum aktuellen Bestückauftrag notwendig sind, und dass sie diese zusätzlichen Arten von Bauteilen (18) den Zuführeinrichtungen (7) zuweist, welche vor Beendigung des aktuellen Bestückauftrags mit Bauteilen (18) für den folgenden Bestückauftrag rüstbar sind.

3. Fertigungssystem (1) nach Anspruch 2, wobei die Zentralsteuerung (15) derart ausgebildet ist, dass sie die Zuweisung der zusätzlichen Arten von Bauteilen (18) zu den jeweiligen Zuführeinrichtungen (7) mittels einer Anzeigeeinrichtung (26) anzeigt.

4. Fertigungssystem (1) nach einem der Ansprüche 1 bis 3, wobei jede Zuführeinrichtung (7) aufweist
- eine Fördereinrichtung (19), mittels der die in einem Vorratsbehälter (16, 17) gelagerten Bauteile (18) in einer Förderrichtung zu einer Abholposition transportierbar sind, von welcher die Bauteile (18) von einer Handhabungseinrichtung (9) eines der Zuführeinrichtung (7) zugeordneten Bestückautomaten (6) entnehmbar sind, und
- eine Steuereinrichtung (13), welche derart ausgebildet ist, dass sie eine aktuelle Anzahl an im Vorratsbehälter (16, 17) gelagerten Bauteilen (18) mit einer Anzahl an Bauteilen (18), welche bis zur Fertigstellung eines aktuellen Bestückauftrags, bei dem zumindest ein Substrat (4) mittels des Bestückautomats (6) bestückt wird, von der Zuführeinrichtung (7) zuzuführen ist, vergleicht und das Ergebnis dieses Vergleichs über eine Datenschnittstelle (25) an die daran gekoppelte Zentralsteuerung (15) übermittelt. (1)

5. Fertigungssystem (1) nach Anspruch 4, wobei die Bauteile (18) in der Förderrichtung in einem einheitlichen Abstand (b) in dem Vorratsbehälter (16, 17) angeordnet und durch die Fördereinrichtung (19) in definierten Transportschritten transportierbar sind, und wobei die Steuereinrichtung (13) mit der Fördereinrichtung (19) verbunden und derart ausgebildet ist, dass sie die aktuelle Anzahl an im Vorratsbehälter (16, 17) gelagerten Bauteile (18) basierend auf einer vorgegebenen Gesamtzahl an Bauteilen (18) des vollen Vorratsbehälters (16, 17), dem Abstand der Bauteile (18) in dem Vorratsbehälter (16, 17) und der Anzahl der durchgeführten Transportschritte ermittelt. (2)

6. Fertigungssystem (1) nach Anspruch 5, wobei jede Steuereinrichtung (13) derart ausgebildet ist, dass, falls die aktuelle Anzahl der im Vorratsbehälter (16, 17) gelagerten Bauteile (18) zumindest so groß wie die Anzahl der bis zur Fertigstellung des Bestückauftrags durch die Zuführeinrichtung (7) zuzuführenden Bauteile (18) ist, die Steuereinrichtung (13) diese Information über die Datenschnittstelle (25) an die daran gekoppelte Zentralsteuerung (15) übermittelt. (7)

7. Fertigungssystem (1) nach einem der Ansprüche 4 bis 6, wobei der Vorratsbehälter (16, 17) ein erster Bauteilgurt (16) und zweiter Bauteilgurt (17) ist, in dem die Bauteile (18) in Förderrichtung in einem einheitlichen Abstand gelagert sind und wobei jede Zuführeinrichtung (7) aufweist:
- einen Hauptfördermechanismus (19) der Fördereinrichtung (19), mittels welchem die Bauteile (18) des ersten Bauteilgurts (16) oder des zweiten Bauteilgurts (17) in einer Förderrichtung zu der Abholposition transportierbar sind,
- eine Erfassungseinrichtung (22), welche in Förderrichtung vor der Abholposition vorgesehen ist, um das Ende des jeweiligen durch den Hauptfördermechanismus (19) geförderten ersten oder zweiten Bauteilgurts (16, 17) zu erfassen,
- einen ersten Hilfsfördermechanismus (20) der Fördereinrichtung (19), um den ersten Bauteilgurt (16) im Anschluss an das Ende des zweiten Bauteilgurts (17) dem Hauptfördermechanismus (19) zuzuführen, falls die Erfassungseinrichtung (22) das Ende des zweiten Bauteilgurts (17) erfasst,
- einem zweiten Hilfsfördermechanismus (21) der Fördereinrichtung (19), um den zweiten Bauteilgurt (17) im Anschluss an das Ende des ersten Bauteilgurts (16) dem Hauptfördermechanismus (19) zuzuführen, falls die Erfassungseinrichtung (22) das Ende des ersten Bauteilgurts (16) erfasst. (9)

8. Fertigungssystem (1) nach Anspruch 7, wobei jede Zuführeinrichtung (7) eine Schneideeinrichtung (23, 24) zum Durchtrennen des ersten und zweiten Bauteilgurts (16, 17) aufweist, wobei die Bauteile (18) in dem ersten und zweiten Bauteilgurt (16, 17) in einem einheitlichen Abstand (b) zueinander gelagert sind und die Schneideeinrichtung (23, 24) in Förderrichtung in einer vorgegebenen Distanz (c) zur Abholposition angeordnet und mit der Steuereinrichtung (13) verbunden ist, und wobei die Steuereinrichtung (13) derart ausgebildet ist, dass sie denjenigen Bauteilgurt (16, 17), welcher von dem Hauptfördermechanismus gefördert wird, mittels der Schneideeinrichtung (23, 24) durchtrennt, wenn die Anzahl der zur Fertigstellung des aktuellen Bestückauftrags von der Zuführeinrichtung (7) zuzuführenden Bauteile (18) gleich oder kleiner der Anzahl der sich zwischen der Schneideeinrichtung (23, 24) und der Abholposition befindlichen Bauteile (18) ist. (10)

9. Fertigungssystem (1) nach einem der Ansprüche 7 und 8, wobei jede Steuereinrichtung (13) derart ausgebildet ist, dass sie nach Fertigstellung des aktuellen Bestückauftrags den Bauteilgurt (16, 17), welcher im Anschluss an das Ende des durchtrennten Bauteilgurts (16, 17) zugeführt wird, mittels des Hauptfördermechanismus solange fördert, bis sich ein Bauteil (18) dieses Bauteilgurts (16, 17) an der Anholposition befindet. (12)

10. Fertigungsverfahren für ein Fertigungssystem (1) nach Anspruch 1, wobei die Zentralsteuerung (15) basierend auf der Information, dass die aktuelle Anzahl der Bauteile (18), die von Zuführeinrichtung (7) aktuell vorrätig gehalten wird, mindestens so groß ist wie die Anzahl der Bauteile (18), welche bis zur Fertigstellung des aktuellen Bestückauftrags von der Zuführeinrichtung (7) zuzuführen ist, bestimmt, dass diese Zuführeinrichtung (7) vor Beendigung des aktuellen Bestückauftrags mit Bauteilen (18) für den folgenden Bestückauftrag rüstbar ist.

11. Fertigungsverfahren nach Anspruch 10, wobei mehrere Zuführeinrichtungen (7) an dem Bestückautomaten (6) gekoppelt sind und die Zentralsteuerung (15) basierend auf vorgegebenen fertigungsrelevanten Daten bezüglich des aktuellen Bestückauftrags und bezüglich des folgenden Bestückauftrags bestimmt, welche zusätzlichen Arten von Bauteilen (18) zur Durchführung des folgenden Bestückauftrags im Vergleich zum aktuellen Bestückauftrag notwendig sind, und diese zusätzlichen Arten von Bauteilen (18) den Zuführeinrichtungen (7) zuweist, welche vor Beendigung des aktuellen Bestückauftrags mit Bauteilen (18) für den folgenden Bestückauftrag rüstbar sind.
